# EUROPÄISCHE PATENTSCHRIFT

(11) **EP 2 761 652 B1**
(45) Veröffentlichungstag und Bekanntmachung des Hinweises auf die Patenterteilung: **13.01.2016**
(21) Anmeldenummer: 12774970.3
(22) Anmeldetag: 20.09.2012
(51) Int. Cl.: H01L 23/495, H01L 21/48, H01L 23/31, B24C 1/00

(54) **VERFAHREN ZUR HERSTELLUNG EINER LÖTVERBINDUNG**
METHOD FOR PRODUCING A SOLDER JOINT
PROCÉDÉ DESTINÉ À RÉALISER UNE LIAISON PAR BRASAGE

(30) Priorität: 29.09.2011 DE 102011083791
(43) Veröffentlichungstag der Anmeldung: 06.08.2014
(73) Patentinhaber: Robert Bosch GmbH, 70442 Stuttgart (DE)
(72) Erfinder: MICHELS, Daniel, 72768 Reutlingen (DE); GREEN, Simon, 72793, Pfullingen (DE)
(86) Internationale Anmeldenummer: PCT/EP2012/068577
(87) Internationale Veröffentlichungsnummer: WO 2013/045348

(56) Entgegenhaltungen:
- EP-A1- 0 987 747
- EP-A2- 0 326 097
- EP-A2- 0 687 008
- 3m: "Rocatec Verbundsystem Wissenschaftliches Produkt Profil", 3M ESPE schientific Affairs 12/01, 31. Dezember 2001 (2001-12-31), XP55048766, Gefunden im Internet: URL:http://multimedia.3m.com/mws/mediawebs erver?mwsId=66666UF6EVsSyXTtl8TcNxTaEVtQEV s6EVs6EVs6E666666--&fn=rocatec_tp_de.pdf [gefunden am 2013-01-07]

## Beschreibung

### Stand der Technik

Die vorliegende Erfindung betrifft ein Verfahren zur Herstellung einer Lötverbindung zwischen einem Basisteil und einem Bauteil sowie eine elektronische Baugruppe und ein Moldmodul.

Verfahren zur Herstellung von Lötverbindungen sind aus dem Stand der Technik in unterschiedlichen Ausgestaltungen bekannt. Hierbei werden z. B. bei der Fertigung von Leistungsmodulen für Steuergeräte im Kraftfahrzeugbereich elektrische oder elektronische Bauteile, insbesondere Leistungs-Halbleiter, direkt auf metallische Basisteile, wie z. B. Stanzgitter oder Wärmesenken, gelötet und anschließend vollständig oder teilweise mit einem duroplastischen Kunststoff ummoldet. Dabei ist die Haftfähigkeit des Kunststoffs auf dem Basisteil in vielen Fällen unzureichend, um mechanische Spannungen bedingt durch unterschiedliche thermische Ausdehnungskoeffizienten der Bauteile aufzunehmen. Zur Verbesserung der Haftung können die Basisteile aufgerauht werden, wie beispielsweise in EP 0 987 747 oder EP 0 687 008 beschrieben.

Beim Lötvorgang besteht zudem die Gefahr des Verschwimmens der Bauteile. Dies kann zu einer schlechten Entwärmbarkeit/Wärmeabfuhr bzw. inhomogenen Wärmespreizung führen, wenn das Bauteil beim Lötprozess z. B. an einen Rand des Basisteils verschwimmt. Das Verschwimmen führt in vielen Fällen zu einem Bauteil-Ausschuss, weil die exakte Positionierung des Bauteils auf dem Basisteil nicht mehr gegeben ist.

### Offenbarung der Erfindung

Das erfindungsgemäße Verfahren mit den Merkmalen des Anspruchs 1 weist demgegenüber den Vorteil auf, dass durch eine Oberflächenbehandlung eine deutliche Haftverbesserung von Gehäusewerkstoffen auf einem Basisteil erreicht wird und gleichzeitig Bereiche, auf denen die Oberflächenbehandlung erfolgt ist, für Lote nicht mehr benetzbar sind. Dies wird erfindungsgemäß dadurch erreicht, dass auf einem bereitgestellten Basisteil ein SACO-Strahlprozess (SAndblast COating beispielsweise der Fa. Delo) mit einem nur teilweisen Strahlen einer Oberfläche des Basisteils mit einem SACO-Strahlmittel derart durchgeführt wird, dass ein SACO-gestrahlter Bereich und ein ungestrahlter Positionierungsbereich vorhanden sind. Anschließend erfolgt das Anlöten des zumindest ersten Bauteils auf einem nicht SACO-gestrahlten Bereich des Basisteils, wobei der SACO-gestrahlte Bereich als Lötstopp fungiert. Dadurch kann das Verschwimmen der Bauteile verhindert und gleichzeitig ein Auslaufen des Lotes in den SACO-gestrahlten Bereich und daraus resultierende inhomogene Wärmespreizungen wirksam unterdrückt werden. Das Basisbauteil und zumindest ein auf einem nicht SACO-gestrahlten Bereich des Basisteils derart befestigtes Bauteil bilden bevorzugt eine elektronische Baugruppe. Durch die auf dem gestrahlten Bereich des Basisteils verbleibenden Silikatrückstände des SACO-Strahlguts wird ein wesentlich verbessertes Haftvermögen von Gehäusewerkstoffen, insbesondere duroplastischen Kunststoffen, auf dem gestrahlten Bereich erreicht. Ferner wird eine verbesserte Aufnahme von mechanischen Spannungen im Basisteil erreicht, die durch unterschiedliche thermische Ausdehnungskoeffizienten der Bauteile verursacht werden.

Die Unteransprüche zeigen bevorzugte Weiterbildungen der Erfindung.

Vorzugsweise weist das Basisteil mehrere Seiten auf und nur eine Seite des Basisteils weist den SACO-gestrahlten Bereich und den ungestrahlten Positionierungsbereich auf. Weiterhin bevorzugt weist das Basisteil mehrere Seiten auf und mehrere Seiten des Basisteils weisen SACO-gestrahlte Bereiche auf. Folglich können in einem einzigen zeit- und kosteneffizienten Verfahrensschritt eine oder mehrere Seiten des vorzugsweise aus einem metallischen Material hergestellten Basisteils bereitgestellt werden, die sowohl ein verbessertes Haftvermögen gegenüber Kunststoff als auch Oberflächeneigenschaften aufweisen, die eine Lot-Benetzung verhindern. Das Verfahren ist somit für unterschiedliche Bauformen von Basisteilen universell einsetzbar.

Weiterhin bevorzugt wird der ungestrahlte Positionierungsbereich vor dem SACO-Strahlen mittels einer Schattenmaske maskiert. Somit können auf einfache und betriebssichere Art und Weise maskierte Basisteile bereitgestellt werden, die den nachfolgenden Verfahrensschritt des Strahlens mit hohen Taktzeiten ermöglichen. Zudem können die Schattenmasken mit minimalem Zeit- und Materialaufwand auf die Basisteile aufgebracht werden.

Gemäß einer bevorzugten Ausgestaltung der Erfindung sind wenigstens zwei Positionierungsbereiche am Basisteil zur Befestigung eines ersten und zweiten Bauteils vorgesehen. Dadurch ist es mit minimalen Gesamtkosten und ohne wesentlichen zeitlichen Mehraufwand möglich, Basisteile für eine mögliche Mehrfachbestückung von Bauteilen zu fertigen und auf diese Weise bevorzugt eine elektronische Baugruppe bereitzustellen.

Vorzugsweise erfolgt nach dem Anlöten des Bauteils auf den Positionierungsbereich ein Molden eines Moldgehäuses. Hierbei umschließt das Moldgehäuse zumindest einen Teil des Basisteils, das somit im eingebauten Zustand, z. B. in einem Steuergerät eines Fahrzeugs, vor Umwelteinflüssen geschützt ist. Somit werden eine hohe Betriebssicherheit sowie Dauerhaltbarkeit sichergestellt. Zudem können Teile der Oberfläche des Basisteils vom umgebenden Moldgehäuse ausgespart bleiben, so dass eine effiziente Abfuhr der beim Betrieb in den Bauteilen entstehenden Wärme gewährleistet ist. Zudem wird eine daraus resultierende Delamination bzw. Ablösung an der Grenzfläche zwischen Moldmasse und Basisteil wirksam verhindert.

Die Erfindung betrifft ferner eine elektronische Baugruppe, umfassend zumindest ein erstes Bauteil und ein Basisteil, wobei das Basisteil zumindest einen mit einem SACO-Strahlmittel, dessen Strahlgut eine Silikatbeschichtung aufweist, gestrahlten Bereich und wenigstens einen ungestrahlten Positionierungsbereich aufweist. Hierbei ist das Bauteil am ungestrahlten Positionierungsbereich angeordnet, bevorzugt durch Löten, wobei Silikatpartikel am SACO-gestrahlten Bereich anhaften.

Gemäß einer weiteren bevorzugten Ausgestaltung der Erfindung ist der SACO-gestrahlte Bereich frei von Lot. Der SACO-gestrahlte Bereich stellt eine zuverlässige lokale Begrenzung für die mit Lot benetzbare Positionierungsfläche der Bauteile bereit. Dadurch werden ein Verschwimmen der Bauteile beim Lötvorgang sowie ein Auslaufen des Lots aus der Positionierungsfläche (Lotstop) bzw. die Bildung von Lotkränzen um die Bauteile zuverlässig verhindert.

Vorzugsweise ist das Basisteil als Kupfer-Stanzgitter oder als Kupfer-Wärmesenke ausgebildet. Somit können die Basisteile, z. B. in Form von Leistungs-Halbleiterelementen auf einfache Weise direkt auf das Kupfer-Stanzgitter bzw. die Kupfer-Wärmesenke gelötet werden und ohne Verschwimmen exakt positioniert werden.

Weiterhin bevorzugt weist das Basisteil mehrere Seiten auf und nur eine Seite des Basisteiles weist den SACO-gestrahlten Bereich auf. Dadurch können auf einfache Weise ein einseitiges Anlöten der Bauteile sowie deren Kontaktierung, beispielsweise durch eine Aluminium-Dickdrahtbondung, Auflöten von Kupfer-Clips oder Kombinationen davon, bei der Fertigung erfolgen.

Aus den Oberflächeneigenschaften des gestrahlten Bereichs resultiert ein deutlich verbessertes Haftvermögen eines Gehäusewerkstoffes, beispielsweise eines Moldgehäuses, am Basisteil der elektronischen Baugruppe. Hierbei umschließt das Moldgehäuse zumindest einen Teil des Basisteils, wodurch ein Moldmodul gebildet ist. Das Moldmodul ist auf dieser Weise zuverlässig vor eindringenden Umwelteinflüssen abgedichtet und geschützt, die ansonsten Fehlfunktionen bzw. einen Ausfall des Moldmodules verursachen können. Bevorzugt werden duroplastische Kunststoffmaterials zur Ausbildung des Moldgehäuses vorgesehen. Die Verwendung eines duroplastischen Kunststoffmaterials ermöglicht eine wärmeresistente und betriebssichere Ummantelung des gesamten Moldmoduls

### Zeichnung

Nachfolgend werden bevorzugte Ausführungsbeispiele der Erfindung unter Bezugnahme auf die begleitende Zeichnung im Detail beschrieben. In der Zeichnung ist:
- Figur 1: eine vergrößerte schematische Schnittansicht eines erfindungsgemäßen Moldmoduls,
- Figur 2: eine vergrößerte schematische Draufsicht eines Basisteils gemäß einem ersten bevorzugten Ausführungsbeispiel der Erfindung vor einem Strahlvorgang,
- Figur 3: eine vergrößerte schematische Draufsicht des Basisteils von Figur 2 nach dem Strahlvorgang,
- Figur 4: eine vergrößerte schematische Darstellung eines SACO-Strahlvorgangs vor einem Aufprall eines Strahlkorns,
- Figur 5: eine vergrößerte schematische Darstellung des SACO-Strahlvorgangs beim Aufprall des Strahlkorns, und
- Figur 6: eine vergrößerte schematische Darstellung des SACO-Strahlvorgangs nach dem Abprall des Strahlkorns,
- Figur 7: eine vergrößerte schematische Draufsicht eines Basisteils des Moldmoduls gemäß einem zweiten Ausführungsbeispiel der Erfindung vor dem Strahlvorgang, und
- Figur 8: eine vergrößerte schematische Draufsicht des Basisteils von Figur 7 nach dem Strahlvorgang.

### Bevorzugte Ausführungsformen der Erfindung

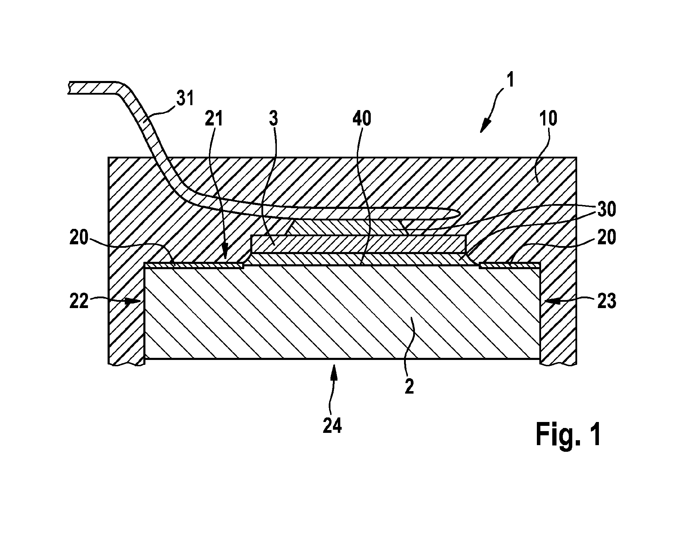

Nachfolgend wird unter Bezugnahme auf die Figuren 1 bis 6 ein erfindungsgemäßes Moldmodul 1 und ein Basisteil 2 gemäß einem ersten bevorzugten Ausführungsbeispiel der Erfindung sowie ein Verfahren zur Herstellung einer Lötverbindung im Detail beschrieben.

Wie aus der vereinfachten schematischen Schnittdarstellung des erfindungsgemäßen Moldmoduls 1 von Figur 1 ersichtlich ist, umfasst das Moldmodul 1 ein Moldgehäuse 10 sowie ein metallisches Basisteil 2, das im Innern des Moldgehäuses 10 angeordnet ist. Hierbei ist das Basisteil 2 als Kupfer-Wärmesenke ausgebildet. Wie aus Figur 1 weiter ersichtlich, umschließt das Moldgehäuse 10 eine Seite 21 sowie deren angrenzende Seiten 22, 23 des Basisteils 2, während eine der Seite 21 gegenüberliegende Seite 24 des Basisteils 2 vom Moldgehäuse 10 nicht umschlossen ist.

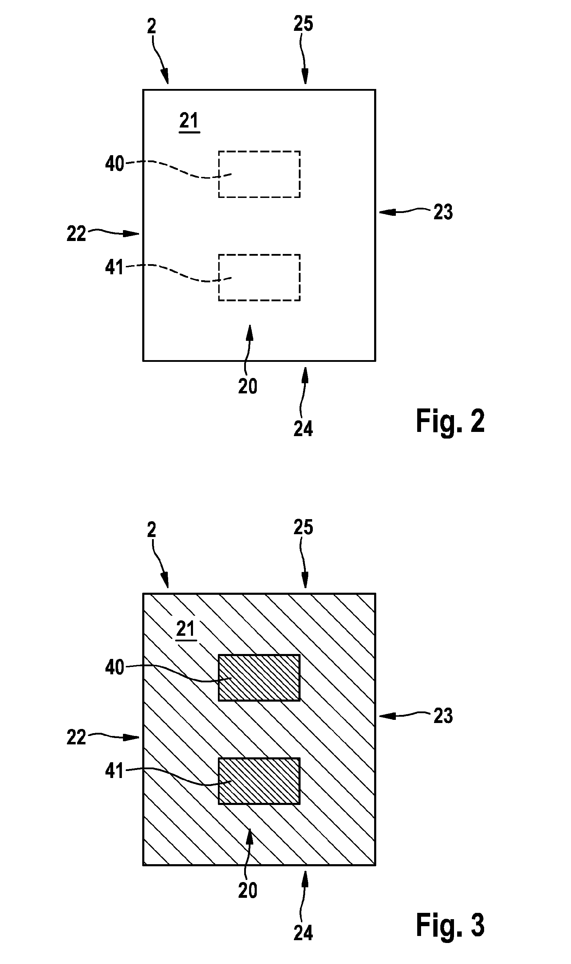

Die Seite 21 des Basisteils 2 weist bei diesem ersten Ausführungsbeispiel zwei im Wesentlichen symmetrische angeordnete Positionierungsbereiche 40, 41 auf, auf denen ein Bauteil 3 bzw. ein zweites, hier nicht sichtbares Bauteil mittels eines Lots 30 befestigt sind, sowie einen SACO-gestrahlten Bereich 20 auf, der die Positionierungsbereiche 40, 41 umgibt, wie dies in Figur 2 dargestellt ist. Ferner ist ein Anschlussdraht 31 am Bauteil 3 (bzw. ein weiterer hier nicht sichtbarer Anschlussdraht am zweiten Bauteil) mittels Lot 30 befestigt und aus dem Moldgehäuse 10 herausgeführt. Das Basisteil 2 kann alternativ auch als Kupfer-Stanzgitter ausgebildet sein.

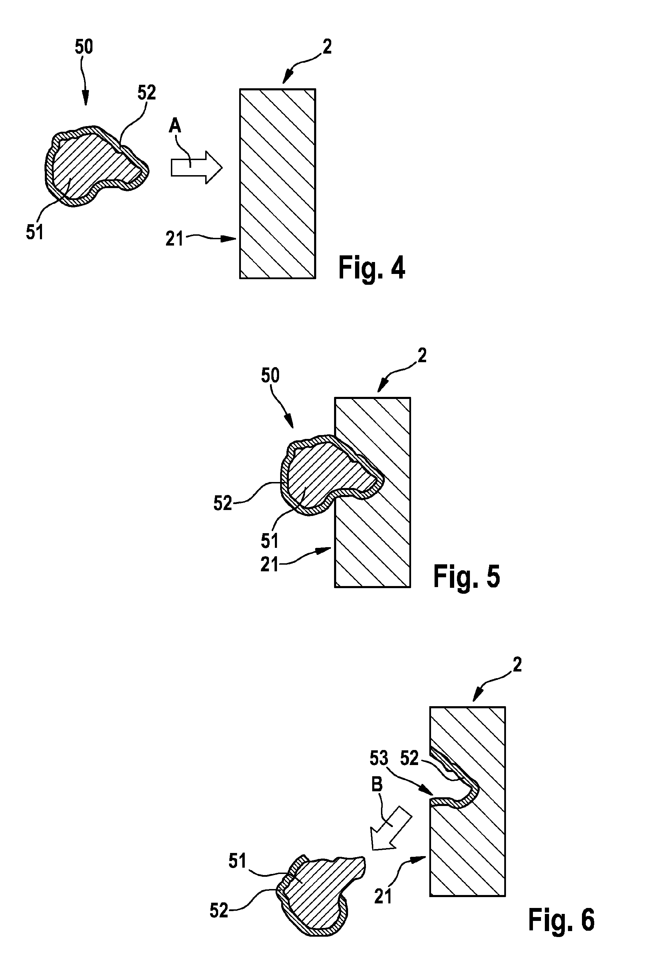

Die Positionierungsflächen 40, 41 werden bei der Fertigung z. B. mittels einer Schattenmaske maskiert, um deren Kupferoberfläche als Lotfläche zu schützen, während die verbleibende, unmaskierte Fläche (die den späteren SACO-gestrahlten Bereich 20 darstellt) zur Haftverbesserung einem SACO-Sandstrahlen unterzogen wird. Hierbei wird ein spezielles Strahlmittel mit einem Strahlgut 50 verwendet, von dem jedes Korn 51, wie in Figur 4 dargestellt, mit einer Silikatbeschichtung 52 versehen ist und in Richtung eines Pfeils A auf die Seite 21 des Basisteils 2 gestrahlt wird.

Wie in Figur 5 dargestellt, dringt das Korn 51 hierbei beim Aufprall teilweise in das Basisteil 2 ein. Wenn das Korn 51, wie in Figur 6 dargestellt, wieder vom Basisteil 2 in Richtung eines Pfeils B abprallt, verbleibt ein Teil der Silikatbeschichtung 52 in einer durch den Strahlprozess erzeugten Ausnehmung 53. Auf diese Weise wird der in Figur 3 dargestellte SACO-gestrahlte Bereich 20 erzeugt. Der SACO-gestrahlte Bereich 20 weist einerseits eine erhöhte Oberflächenrauhigkeit auf, die eine Haftung von Kunststoffen wesentlich verbessert, und die verbleibenden Rückstände der Silikatbeschichtung 52 jedes Korns 51 des Strahlguts 50 begünstigen bzw. verbessern andererseits das Haftvermögen von Kunststoffen in noch stärkerem Maße und machen gleichzeitig eine Benetzung mit Lot unmöglich. Durch das erfindungsgemäße Verfahren werden somit gleichzeitig beide Funktionen, die einer Haftverbesserung von Kunststoffen, vorzugsweise auf Metalloberflächen, und die eines Lötstopps auf denselben bereitgestellt. Dies ist insbesondere für die Fertigung von Moldmodulen von Vorteil, die als Leistungsmodule in Steuergeräten im Kraftfahrzeugbereich verwendet werden.

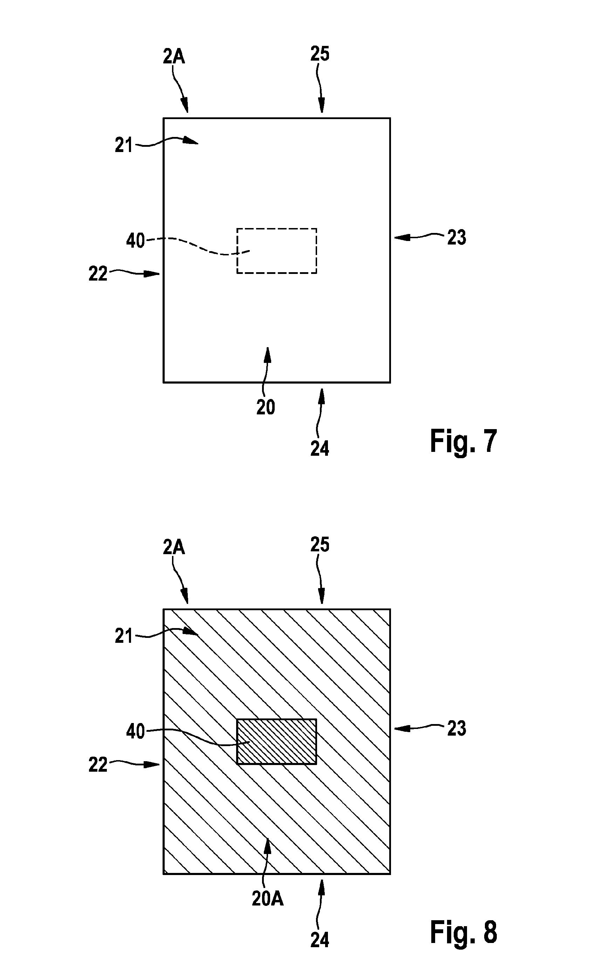

Nachfolgend wird unter Bezugnahme auf Figur 7 und 8 ein Basisteil des Moldmoduls 1 gemäß einem zweiten bevorzugten Ausführungsbeispiel der Erfindung detailliert beschrieben. Gleiche oder funktional gleiche Bauteile sind hier mit denselben Bezugszeichen wie im ersten Ausführungsbeispiel bezeichnet.

Im Gegensatz zum zuvor beschriebenen ersten Ausführungsbeispiel weist das zweite Ausführungsbeispiel lediglich eine einzige Positionierungsfläche 40 auf, welche auf der Seite 21 eines Basisteils 2A, wie in Figur 7 dargestellt, vorgesehen ist und die nach dem Strahlvorgang, wie in Figur 8 dargestellt, von einem SACO-gestrahlten Bereich 20A vollständig umgeben ist.

Grundsätzlich sind die Ausführungen gemäß Fig. 3 und 8 jeweils ohne Vorsehen eines Moldgehäuses denkbar. In diesen Fällen liegen elektronische Baugruppen vor, bei welchen durch die vorgesehenen SACO-gestrahlten Bereich 20 ein Lötstopp eines umschlossenen Lotkontaktbereiches sichergestellt ist.

## Patentansprüche

1. Verfahren zur Herstellung einer Lötverbindung zwischen zumindest einem Basisteil (2) und zumindest einem ersten Bauteil (3), umfassend die Schritte
- Bereitstellen des Basisteils (2),
- teilweises Strahlen einer Oberfläche des Basisteils (2) mit einem SACO-Strahlmittel, dessen Strahlgut (50) eine Silikatbeschichtung (52) aufweist, derart, dass ein SACO-gestrahlter Bereich (20) und ein ungestrahlter Positionierungsbereich (40) vorhanden sind, und
- Anlöten des zumindest ersten Bauteils (3) auf dem ungestrahlten Positionierungsbereich (40),
- wobei der SACO-gestrahlte Bereich (20) als Lötstopp fungiert.

2. Verfahren nach Anspruch 1, **dadurch gekennzeichnet, dass** das Basisteil (2) mehrere Seiten (21, 22, 23, 24, 25) aufweist und nur eine Seite (21) des Basisteils (2) den SACO-gestrahlten Bereich (20) und den ungestrahlten Positionierungsbereich (40) aufweist.

3. Verfahren nach Anspruch 1, **dadurch gekennzeichnet, dass** das Basisteil (2) mehrere Seiten (21, 22, 23, 24, 25) aufweist und mehrere Seiten (21, 22, 23, 24, 25) des Basisteils (2) SACO-gestrahlte Bereiche aufweisen.

4. Verfahren nach einem der vorhergehenden Ansprüche, **dadurch gekennzeichnet, dass** der ungestrahlte Positionierungsbereich (40) vor dem Saco-Strahlen mittels einer Schattenmaske maskiert wird.

5. Verfahren nach einem der vorhergehenden Ansprüche, **dadurch gekennzeichnet, dass** wenigstens zwei Positionierungsbereiche (40, 41) am Basisteil (2) zur Befestigung eines ersten und zweiten Bauteils vorgesehen wird.

6. Verfahren nach einem der vorhergehenden Ansprüche, **dadurch gekennzeichnet, dass** nach dem Anlöten des Bauteils (3) auf den Positionierungsbereich (40) ein Molden eines Moldgehäuses (10) erfolgt.

7. Elektronische Baugruppe, umfassend:
- zumindest ein erstes Bauteil (3) und
- ein Basisteil (2),
- wobei das Basisteil (2) zumindest einen mit einem SACO-Strahlmittel, dessen Strahlgut eine Silikatbeschichtung aufweist, gestrahlten Bereich (20) und wenigstens einen ungestrahlten Positionierungsbereich (40) aufweist,
- wobei das Bauteil (3) am ungestrahlten Positionierungsbereich (40) angelötet ist,
- wobei Silikatpartikel am SACO-gestrahlten Bereich (20) anhaften und wobei der SACO-gestrahlte Bereich (20) für das Lot nicht benetzbar ist.

8. Elektronische Baugruppe nach Anspruch 7, **dadurch gekennzeichnet, dass** das Basisteil (2) als Kupfer-Stanzgitter oder als Kupfer-Wärmesenke ausgebildet ist.

9. Elektronische Baugruppe nach einem der Ansprüche 7 oder 8, **dadurch gekennzeichnet, dass** das Basisteil (2) mehrere Seiten (21, 22, 23, 24, 25) aufweist und nur eine Seite (21) des Basisteils (2) den SACO-gestrahlten Bereich (20) aufweist.

10. Moldmodul, **dadurch gekennzeichnet, dass** es eine elektronische Baugruppe nach einem der Ansprüche 7 - 9 und ein Moldgehäuse umfasst, wobei das Moldgehäuse (10) am SACO-gestrahlten Bereich (20) am Basiselement (2) anhaftet.

11. Moldmodul nach Anspruch 10, **dadurch gekennzeichnet, dass** das Moldgehäuse (10) ein Duroplast ist.

## Claims

1. Method for producing a solder joint between at least one base part (2) and at least a first component (3), comprising the following steps:
- providing the base part (2),
- partially blasting a surface of the base part (2) with a SACO blasting agent, the blasting material (50) of which has a silicate coating (52), in such a way that a SACO-blasted region (20) and an unblasted positioning region (40) are present, and
- soldering the at least first component (3) onto the unblasted positioning region (40),
- wherein the SACO-blasted region (20) acts as a solder resist.

2. Method according to Claim 1, **characterized in that** the base part (2) comprises a number of sides (21, 22, 23, 24, 25) and only one side (21) of the base part (2) has the SACO-blasted region (20) and the unblasted positioning region (40).

3. Method according to Claim 1, **characterized in that** the base part (2) comprises a number of sides (21, 22, 23, 24, 25) and a number of sides (21, 22, 23, 24, 25) of the base part (2) have SACO-blasted regions.

4. Method according to one of the preceding claims, **characterized in that** the unblasted positioning region (40) is masked by means of a shadow mask prior to the SACO blasting.

5. Method according to one of the preceding claims, **characterized in that** at least two positioning regions (40, 41) are provided on the base part (2) for attaching a first component and a second component.

6. Method according to one of the preceding claims, **characterized in that**, after soldering the component (3) onto the positioning region (40), moulding of a molded housing (10) takes place.

7. Electronic assembly comprising:
- at least a first component (3) and
- a base part (2),
- wherein the base part (2) has at least one region (20) blasted with a SACO blasting agent, the blasting material of which has a silicate coating, and at least one unblasted positioning region (40),
- wherein the component (3) is soldered on the unblasted positioning region (40),
- wherein silicate particles adhere to the SACO-blasted region (20) and wherein the SACO-blasted region (20) is not wettable with solder.

8. Electronic assembly according to Claim 7, **characterized in that** the base part (2) is embodied as a copper leadframe or as a copper heat sink.

9. Electronic assembly according to either of Claims 7 and 8, **characterized in that** the base part (2) has a number of sides (21, 22, 23, 24, 25) and only one side (21) of the base part (2) has the SACO-blasted region (20).

10. Mould module, **characterized in that** it comprises an electronic assembly according to one of Claims 7 - 9 and a molded housing, wherein the molded housing (10) adheres to the SACO-blasted region (20) on the base element (2).

11. Mould module according to Claim 10, **characterized in that** the molded housing (10) is a thermosetting plastic.

## Revendications

1. Procédé destiné à réaliser une liaison par brasage entre au moins une partie de base (2) et au moins un premier composant (3), comprenant les étapes suivantes
- fourniture de la partie de base (2),
- grenailler partiellement une surface de la partie de base (2) avec un agent de grenaillage de type SACO dont les éléments de grenaillage (50) présentent un revêtement de silicate (52), de manière à obtenir une zone (20) ayant subi un grenaillage de type SACO et une zone de positionnement (40) n'ayant pas subi de grenaillage, et
- fixer par brasage l'au moins un premier composant (3) sur la zone de positionnement (40) n'ayant pas subi de grenaillage,
- la zone (20) ayant subi un grenaillage de type SACO servant à arrêter le brasage.

2. Procédé selon la revendication 1, **caractérisé en ce que** la partie de base (2) présente plusieurs côtés (21, 22, 23, 24, 25) et seulement un côté (21) de la partie de base (2) présente la zone (20) ayant subi un grenaillage de type SACO et la zone de positionnement (40) n'ayant pas subi de grenaillage.

3. Procédé selon la revendication 1, **caractérisé en ce que** la partie de base (2) présente plusieurs côtés (21, 22, 23, 24, 25) et plusieurs côtés (21, 22, 23, 24, 25) de la partie de base (2) présentent des zones ayant subi un grenaillage de type SACO.

4. Procédé selon l'une quelconque des revendications précédentes, **caractérisé en ce que** la zone de positionnement (40) n'ayant pas subi de grenaillage est masquée avec un masque.

5. Procédé selon l'une quelconque des revendications précédentes, **caractérisé en ce qu'**au moins deux zones de positionnement (40, 41) sont prévues sur la partie de base (2) pour la fixation d'un premier et d'un deuxième composant.

6. Procédé selon l'une quelconque des revendications précédentes, **caractérisé en ce qu'**après la fixation par brasage du composant (3) sur la zone de positionnement (40), il se produit un moulage d'un boîtier de moule (10).

7. Module électronique, comprenant :
- au moins un premier composant (3) et
- une partie de base (2),
- la partie de base (2) présentant au moins une zone (20) ayant subi un grenaillage avec un agent de grenaillage de type SACO dont les éléments de grenaillage présentent un revêtement de silicate et au moins une zone de positionnement (40) n'ayant pas subi de grenaillage,
- le composant (3) étant fixé par brasage à la zone de positionnement (40) n'ayant pas subi de grenaillage,
- des particules de silicate adhérant à la zone (20) ayant subi un grenaillage de type SACO, et la zone (20) ayant subi un grenaillage de type SACO ne pouvant pas être mouillée pour le brasage.

8. Module électronique selon la revendication 7, **caractérisé en ce que** la partie de base (2) est réalisée sous forme de grille estampée en cuivre ou sous forme de puits thermique en cuivre.

9. Module électronique selon l'une quelconque des revendications 7 ou 8, **caractérisé en ce que** la partie de base (2) présente plusieurs côtés (21, 22, 23, 24, 25) et seulement un côté (21) de la partie de base (2) présente la zone (20) ayant subi un grenaillage de type SACO.

10. Module de moule, **caractérisé en ce qu'**il comprend un module électronique selon l'une quelconque des revendications 7 à 9, et un boîtier de moule, le boîtier de moule (10) adhérant à l'élément de base (2) au niveau de la zone (20) ayant subi un grenaillage de type SACO.

11. Module de moule selon la revendication 10, **caractérisé en ce que** le boîtier de moule (10) est un matériau thermodurcissable.
